# EUROPEAN PATENT APPLICATION

(11) **EP 4 546 007 A1**
(43) Date of publication of application: **30.04.2025**
(21) Application number: 24207604.0
(22) Date of filing: 18.10.2024
(51) Int. Cl.: G01S 7/481, H05K 9/00, H05K 1/18, H05K 3/28

(54) **OPTICAL SENSOR MODULE**

(30) Priority: 25.10.2023 FR 2311581
(71) Applicant: STMicroelectronics International N.V., 1228 Plan-les-Ouates, Geneva (CH)
(72) Inventor: MAO, Yandong, SHANGHAI, 200240 (CN); TEO, Tat Ming, 797463 SINGAPORE (SG); WILLIAMS, Fraser, EDINBURGH, EH11 2BY (GB)
(74) Representative: Cabinet Beaumont

(57) **Abstract**

The present disclosure relates to an optical sensor module (200) comprising:
- a substrate (102) comprising first conductive pads (106);
- a module cap (130) assembled on the substrate;
- a connecting flex (230) incorporated in the module cap, the connecting flex being adapted to electrically couple at least one of the first conductive pads (106) to at least one component (152) mounted on and/or inside the module cap;
the connecting flex comprising at least one metal layer covered by, or encapsulated in, at least one dielectric layer.

## Description

### Technical field

The present disclosure relates generally to optical sensors, in particular optical sensor modules.

### Background art

Optical sensors, such as proximity sensors, may be used to detect the presence of nearby objects. Optical sensors are able to do so without physically touching the object. Some types of optical sensors, such as those utilized in optical ranging devices or time of flight sensors, may be used to determine the actual distance to such nearby objects. Optical sensors may be utilized in various electronic devices, such as cameras, phones, including smartphones, smartwatches, tablets, vehicles, machinery, and other devices for detecting the presence of and/or distance to nearby objects. After detecting the presence of the nearby object, the electronic device may be configured to perform a function, such as move a mechanical feature to a secure position, transmit an alarm signal, couple or uncouple an electrical communication, or any other desired function.

Optical sensors typically include components, such as a light-emitting device, a light-receiving sensor (or image sensor), and generally a processing device for processing signals received from the light-receiving sensor. The components of the optical sensor may be formed on a substrate, and a cap may be bonded to the substrate over the components, for example to protect them from damage, thereby forming an optical sensor module, also called optical sensor package. The cap is generally formed with a first opening located over the light-emitting device and a second opening located over the light-receiving sensor.

Generally described, the light-emitting device emits a light signal, or light beam, through the first opening. If an object is outside, and close enough to, the optical sensor module, the light signal may be reflected by the object towards the light-receiving sensor through the second opening. The light-receiving sensor may then generate an electrical signal indicative of the received light signal, which may be transmitted to the processing device for processing said received light signal, for example to determine the presence of, and/or distance to, the proximate object.

The light-emitting device used to generate the light beam is generally covered by a glass for protecting the device from dust, the glass being relatively transparent to light at the wavelengths used. The first opening, which is located over the light-emitting device, may be covered by the glass.

There is a need for improving optical sensor modules, in particular to improve the electrical coupling between the substrate and components mounted inside and/or on the cap, for example between the substrate and a conductive element within the glass, such as a conductive trace.

### Summary of Invention

One embodiment addresses all or some of the drawbacks of known optical sensor modules.

One embodiment provides an optical sensor module comprising:
- a substrate comprising first conductive pads;
- a module cap assembled on the substrate;
- a connecting flex incorporated in the module cap, the connecting flex being adapted to electrically couple at least one of the first conductive pads to at least one component mounted on and/or inside the module cap;
the connecting flex comprising at least one metal layer covered by, or encapsulated in, at least one dielectric layer.

In one embodiment:
- the connecting flex is overmolded in the module cap; and/or
- the module cap is a conductive molded cap, for example formed of a molding material comprising electrically conductive particles dispersed therein.

In one embodiment:
- the at least one metal layer of the connecting flex comprises, for example ends in, a plurality of second conductive pads which are adapted to be coupled to a plurality of the first conductive pads of the substrate; and
- the at least one dielectric layer of the connecting flex comprises, for example ends in, a plurality of insulating elements, each second conductive pad being interposed between two insulating elements.

In one embodiment, the optical sensor module further comprises a light-emitting device, the module cap at least partially covering the light-emitting device and comprising a first opening located over said light-emitting device, the light-emitting device being for example one of the at least one component.

In one embodiment, the optical sensor module further comprises a glass positioned in the first opening, or between the first opening and the light-emitting device, and/or covering the first opening, and adapted to transmit light signals emitted by the light-emitting device, the glass including a conductive trace which corresponds to a first component of the at least one component, the connecting flex being electrically coupled to the conductive trace, for example through a conductive wire formed by wire bonding.

In one embodiment, a second component of the at least one component is positioned on the connecting flex. For example, the second component comprises at least part of the light-emitting device.

In one embodiment, the connecting flex includes at least a recess adapted to receive the second component.

In one embodiment, the connecting flex comprises:
- at least one end portion configured to be connected to the substrate, the second conductive pads and the insulating elements being defined in said at least one end portion, and
- an upper portion, said upper portion being at least in part in contact with an internal surface of the module cap, the recess being defined in said upper portion.

In one embodiment, the connecting flex comprises two end portions and two interconnecting portions, wherein each end portion is connected to the upper portion by means of one of the interconnecting portions, each interconnecting portion being disposed substantially perpendicularly to the upper portion.

In one embodiment, the connecting flex comprises:
- a first metal layer electrically coupled to the second component, for example by means of a conductive wire, the first metal layer being covered by a first dielectric layer of the at least one dielectric layer;
- a second metal layer configured to be connected to ground, the second metal layer being covered by a second dielectric layer of the at least one dielectric layer;
- a third metal layer positioned in the recess and electrically isolated from the first metal layer, the second component being connected to said third metal layer, for example positioned on said third metal layer;
- a dielectric core interposed between the first metal layer and the second metal layer;
- at least one connecting via defined in said dielectric core and electrically coupling the third metal layer to the second metal layer. Preferably, the first, second and/or third metal layers are some of the at least one metal layer of the connecting flex.

In one embodiment, the recess goes through the entire thickness of the first dielectric layer and the first metal layer up to the dielectric core.

In one embodiment, the connecting flex comprises a plurality of bond pads, said bond pads being defined on the upper portion of the connecting flex, each bond pad being configured to be electrically coupled to the second component, for example by means of a conductive wire.

In one embodiment, the bond pads go through the entire thickness of the first dielectric layer up to the first metal layer.

### Brief description of drawings

The foregoing features and advantages, as well as others, will be described in detail in the following description of specific embodiments given by way of illustration and not limitation with reference to the accompanying drawings, in which:
Figure 1 is a 3-dimensional view of an example of an optical sensor module;
Figure 2A, Figure 2B and Figure 2C are 3-dimensional views of an optical sensor module according to an embodiment;
Figure 3A is a schematic cross-section view of the connecting flex of Figures 2B and 2C;
Figure 3B is a schematic cross-section view of a connecting flex of an optical sensor module according to another embodiment;
Figure 4A, Figure 4B, Figure 4C, Figure 4D, Figure 4E, Figure 4F, Figure 4G and Figure 4H are top and 3-dimensional views illustrating a method of assembling the connecting flex to the module cap in the optical sensor module of Figure 2A;
Figure 5A is a sectioned 3-dimensional view of an optical sensor module according to another embodiment;
Figure 5B is a top view of the optical sensor module of figure 5A;
Figure 5C is a top view illustrating a detail of the connecting flex of the optical sensor module of figures 5A and 5B; and
Figure 5D is a sectioned 3-dimensional view illustrating a detail of the connecting flex of Figure 5C.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, all the components of an optical sensor have not been detailed, the described embodiments being compatible with the usual optical sensors. For example, the light-emitting device, the light-receiving sensor, and other components of an optical sensor, such as a processing device, have not been detailed. Similarly, all the components of an optical sensor module have not been detailed, the described embodiments being compatible with the usual optical sensor modules.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures, or to an optical sensor module as orientated during normal use.

Unless specified otherwise, the expressions "around", "approximately", "substantially" and "in the order of" signify within 10 %, and preferably within 5 %.

In the following disclosure, unless indicated otherwise, when reference is made to a glass, this includes an element made of a material which is relatively transparent to light at the wavelengths used, for example has a transmission rate of 90 percent or more for these wavelengths. This includes, without being limited to, a glass material or plastic material. The glass may be formed of a solid single material, or may be formed by assembling multiple materials, in which case only part of the glass may be in a transparent material. The glass may comprise, or consist in, a glass window, a lens or a plurality of lenses, and/or an optical filter, more generally an optic.

In the following disclosure, unless indicated otherwise, when reference is made to a filter, reference is made to an optical filter.

In the following disclosure, unless indicated otherwise, when reference is made to a conductive element, for example a conductive trace, pad, strip or lead, reference is made to an electrically conductive element.

In the following disclosure, when reference is made to a connecting flex, or "flex", reference is made to a strip adapted to electrically couple or connect two elements, the strip being both flexible, for example allowing it to be bent according to a given curvature, and mechanically rigid, for example to maintain this curvature once bent.

The embodiments relate to optical sensor modules.

The term "optical sensor module" includes, without being limited to, a proximity sensor module, a time of flight (ToF) module, an ambient light sensor (ALS) module, a 3D Lidar module, and/or a camera module. The term "optical sensor module" also includes an optical sensor module with combined functions, for example a combination of at least two of the above-mentioned modules, or other functions, for example a combination of a proximity detector module with a floodlight and/or a dot projector.

An optical sensor typically includes a light-emitting device and a light-receiving sensor. An optical sensor generally also includes a processing device for processing signals received from the light-receiving sensor. The light-emitting device and the light-receiving sensor may be formed on a substrate, and a cap may be bonded to the substrate over the light-emitting device and the light-receiving sensor, thereby forming an optical sensor module, also called optical sensor package. The cap is generally formed with a first opening located over the light-emitting device and a second opening located over the light-receiving sensor.

As explained in the background section above, the light-emitting device is generally covered by a glass for protecting the device, for example from dust, the glass being relatively transparent to light at the wavelengths used. The glass may cover the first opening. The glass may also function as a diffuser suitable for reducing to some extent the intensity of the emitted light beam, for example for safety reasons, such as protecting a user.

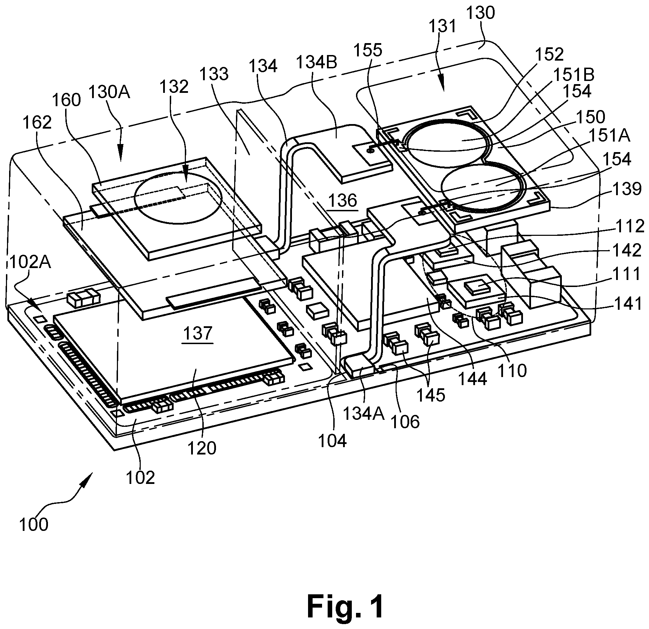

Figure 1 is a 3-dimensional view of an example of an optical sensor module.

The optical sensor module 100 comprises a light-emitting device 110, for example comprising a light emitting diode (LED) such as an infrared LED, and/or a laser such as a vertical cavity surface emitting laser (VCSEL), and a light-receiving sensor 120 (image sensor), for example comprising a photodiode or a plurality of photodiodes, such as SPAD(s). The light-emitting device 110 and the light-receiving sensor 120 are mounted over a substrate 102.

The substrate 102 may be a printed circuit board (PCB).

The light-emitting device 110 is configured to emit a light signal, or a light beam, at a particular frequency or frequency range, and the light-receiving sensor 120 is adapted to detect the emitted light signal in return, for example reflected by an object. In one embodiment, the light-emitting device 110 is configured to emit an infrared (IR) light signal, and the light-receiving sensor 120 is adapted to detect the IR light signal in return, for example reflected by an object.

The light-emitting device 110 of Figure 1 comprises first and second light sources 111, 112 each mounted on respectively a first interposer 141 and a second interposer 142, the first and second interposers 141, 142 being mounted on a top surface 102A of the substrate 102. The first and second light sources 111, 112 are for example first and second VCSELs. In a variant, the light sources may be mounted on the substrate without interposers.

In a variant, the light-emitting device may comprise only one light source, for example a VCSEL, for example mounted on the substrate through an interposer, or even without an interposer.

The light-emitting device 110 may be electrically coupled to the light-receiving sensor 120, for example through the substrate 102.

The top surface 102A of the substrate 102 includes conductive pads 106 (first conductive pads) which are for example at, or close to, edges of the substrate.

The optical sensor module 100 comprises a laser driver 144, configured for controlling the first and second light sources 111, 112. The laser driver 144 may be located in a same cavity as the light-emitting device 110, as described hereafter. This is not limitative and the person skilled in the art can contemplate other configurations.

The optical sensor module 100 may comprise a processing circuit (not shown in Figure 1) which may be configured for processing the light signals emitted by the light-emitting device 110 and received by the light-receiving sensor 120. The processing circuit may be mounted on the top surface 102A of the substrate 102.

The optical sensor module 100 includes other electrical circuits or electronic components, such as surface mounted technology (SMT) components 145 which are also mounted on the top surface 102A of the substrate 102. The SMT components 145 may comprise resistors. Other SMT components may comprise capacitors.

The light-receiving sensor 120 may be coupled to the substrate 102 using conductive connectors, for example conductive wires, and/or may be secured to the substrate 102, such as by an adhesive material or a solder. The adhesive material may be any material suitable for securing the light-receiving sensor 120 to the substrate, such as tape, paste, glue.

A module cap 130 having a first opening 131 and a second opening 132 is attached, or bonded, to the substrate 102 and is adapted to at least partially enclose, or cover, the components which are mounted on the substrate 102, at least the light-emitting device 110, the light-receiving sensor 120, the interposers 141, 142, the laser driver 144 and the SMT components 145. At least partially means that all the components may be not covered, for example the first and second openings do not cover the components which are under said openings. The module cap 130 may be substantially opaque to light at the wavelengths used.

The first and second openings are located at the top face 130A of the module cap 130. The first opening 131 is located over the light-emitting device 110 and the second opening 132 is located over the light-receiving sensor 120. In the illustrated example, the first opening 131 is rectangular and the second opening 132 is circular, but this is not limitative and other forms are possible.

The module cap 130 may include a separation wall 133 between the light-emitting device 110 and the light-receiving sensor 120. The separation wall 133 may form an optical isolator for substantially preventing the internal propagation of light beams between the light-emitting device 110 and the light-receiving sensor 120 within the module cap 130. For example, the separation wall 133 defines first and second cavities 136, 137, the first cavity 136 including the first opening 131 above the light-emitting device 110, and the second cavity 137 including the second opening 132 above the light-receiving sensor 120. The laser driver 144 may be located in the first cavity 136, together with the light-emitting device 110, as indicated above.

The module cap 130 may be a plastic cap, and/or a molded cap formed of a molding material, such as a resin, a Liquid Crystal Polymer (LCP), Nylon, or another engineering plastic. The module cap 130 may be formed using an injection method. In some examples, the module cap may be electrically conductive.

The optical sensor module 100 further comprises:
- a glass 150 positioned in the first opening 131, or between the first opening 131 and the light-emitting device 110, and adapted to transmit the light signals emitted by the light-emitting device; and
- a filter 160, positioned in the second opening 132, or between the second opening 132 and the light-receiving sensor 120, and adapted to transmit the light signals reflected towards the light-receiving sensor.

The glass 150 preferably covers the first opening 131. The glass 150 is preferably attached to the module cap 130. For example, the glass 150 sits on a mounting 139 which is formed within the first opening 131, and is mounted outside the module cap 130. In a variant, the glass could be mounted inside the module cap.

Similarly, the filter 160 preferably covers the second opening 132. The filter 160 is preferably attached to the module cap 130. For example, the filter 160 is positioned inside the module cap 130. In a variant, the filter could be mounted outside the module cap.

The glass 150 may comprise two optical surfaces which may be two beam shapers 151A, 151B, a first beam shaper 151A located over the first light source 111, and a second beam shaper 151B located over the second light source 112. The glass 150 may be a lens, or a lens pad.

The optical sensor module 100 may further comprise a second lens 162 between the filter 160 and the light-receiving sensor 120.

The glass 150 may include a conductive trace 152, which may be embedded in this glass. The glass 150 may further include conductive pads 154 (third conductive pads) coupled to the conductive trace 152, for example two third conductive pads, each at an end of the conductive trace.

The conductive trace may be called "trace" in the following disclosure. The conductive pads may be called "pads" in the following disclosure.

The conductive trace material may be one or a plurality of the following materials: copper (Cu), aluminum (Al), tungsten (W), titanium (Ti), gold (Au), indium-tin oxide (ITO) or another metal or metal alloy.

The conductive trace 152 may be a fine and/or thin trace, for example having a width less than 1 micrometer and/or a thickness less than 100 nanometers, without being limited to these values. The width and thickness of the conductive trace may be a trade-off between its function and the optical transmittivity of the glass. For example, the conductive trace could be wider and/or thicker where the trace is not likely to limit light transmission, and could be finer and/or thinner where the trace may limit light transmission.

Generally, the conductive trace 152 is arranged to be coupled to a conductive rail configured to be at a fixed voltage, for example ground, the conductive rail being generally connected to, or included in, the substrate 102.

The conductive trace 152 may be used as a protection against electromagnetic interferences (EMI) through the first opening 131 of the module cap 130, for example by providing EMI reflection in said first opening. For example, when the optical sensor module 100 is included in an electronic device, electromagnetic interferences may occur between the optical sensor module and the electronic device. The electronic device may be a camera, a smartphone, a smartwatch, a tablet, a vehicle, a machinery, or another device for which it may be useful to detect the presence of and/or distance to nearby objects. The pitch and pattern of the conductive trace can be determined according to the frequencies of the EMI to be managed. For example, the higher frequency, the lower the pitch can be.

The conductive trace 152 may also be used for managing a safety problem related to the light-emitting device 110, that is, to detect whether the glass 150 is removed or otherwise becomes detached from the module cap 130. If the glass 150 is removed or detached, it cannot be used as diffuser suitable for reducing the intensity of the emitted light beam anymore, and cannot protect a user anymore. When the glass 150 is in position, the conductive leads 134, the conductive wires 155 and the conductive trace 152 form a conductive loop, for example through conductive paths in the substrate 102. If, however, the glass 150 becomes detached, the circuit in the conductive loop may be opened, a detection circuit may detect the open circuit, and for example may deactivate the light-emitting device 110.

In a variant which is not illustrated, the filter 160 may also include a second conductive trace.

Examples of conductive trace are described in more detail in the French patent application number 2311561, filed on October 25, 2023 in the name of STMICROELECTRONICS INTERNATIONAL N.V. (law firm reference being B22689), entitled "Optical sensor module", and in the European patent application claiming the priority of the French patent application number 2311561, which are hereby incorporated by reference to the maximum extent allowable by law.

The optical sensor module 100 further comprises two conductive leads 134, assembled to the module cap 130, for example overmolded in the module cap. The conductive leads 134 are configured and positioned in order to electrically couple the conductive trace 152 of the glass 150 to the substrate 102. Conductive leads 134 are generally rigid, and are for example lead frames.

Each conductive lead 134 may be a single conductive piece, for example a single metallic piece.

Each conductive lead 134 comprises a first end 134A coupled, for example connected, to the substrate 102 through one of the first conductive pads 106, and a second end 134B coupled, for example connected, to the conductive trace 152 through one of the third conductive pads 154. The first end 134A of each conductive lead 134 may be coupled to one of the first conductive pads 106 by a conductive adhesive, for example a conductive tape, paste or glue, or a conductive solder. The second end 134B of each conductive lead 134 may be coupled to the third conductive pads 154 by a conductive wire 155 formed by wire bonding, which may be called a "wire bond", or by a conductive adhesive or a conductive solder

Examples of conductive wires are described in more detail in the French patent application number 2311572, filed on October 25, 2023 in the name of STMICROELECTRONICS INTERNATIONAL N.V. (law firm reference being B22688) entitled "Optical sensor module", and in the European patent application claiming the priority of the French patent application number 2311572, which are hereby incorporated by reference to the maximum extent allowable by law.

However, the conductive leads, in particular the lead frames, have some drawbacks.

The lead frames are generally rigid and less tolerant to relative movements of the elements to which they are connected, and/or to dimensional changes between these elements and the lead frames, which could lead to delamination.

In addition, it may be interesting to have multiple pads at the first end 134A of the conductive lead 134. However, it may be difficult to have such multiple pads because it may be difficult to have small pitch between pads, due to the usual method for fabricating the conductive leads such as lead frames. Indeed, the lead frames are usually fabricated by stamping, and, in order to keep the lead frame shape intact, for example to avoid any contact with each other during overmolding, each lead frame should be made wide and thick enough to keep strength, and, as the result, the pad pitch may be quite large, commonly at least 0.4 mm.

The assembly of the conductive leads 134 to the substrate 102, for example using a conductive adhesive or solder, may also require a trench 104 around each first conductive pad 106 to separate the conductive adhesive or solder from other elements, for example other components in the substrate, which may require larger space in the substrate to assemble the conductive leads.

In addition, for example if the module cap 130 is electrically conductive, it may be necessary that the conductive leads are isolated from the module cap. Yet, it may be difficult to make the conductive leads electrically isolated from a conductive module cap.

The inventors propose an optical sensor module making it possible to overcome all or part of the aforementioned drawbacks, in particular to improve the electrical coupling between the substrate and components or conductive elements within the module cap, for example between the substrate and the conductive trace within the glass.

Embodiments of optical sensor modules will be described below. These embodiments are non-limiting and various variants will appear to the person skilled in the art from the indications of the present description.

In the following disclosure, unless indicated otherwise, when reference is made to a component, reference is made to an electronic component, and this includes a conductive element such as a conductive trace.

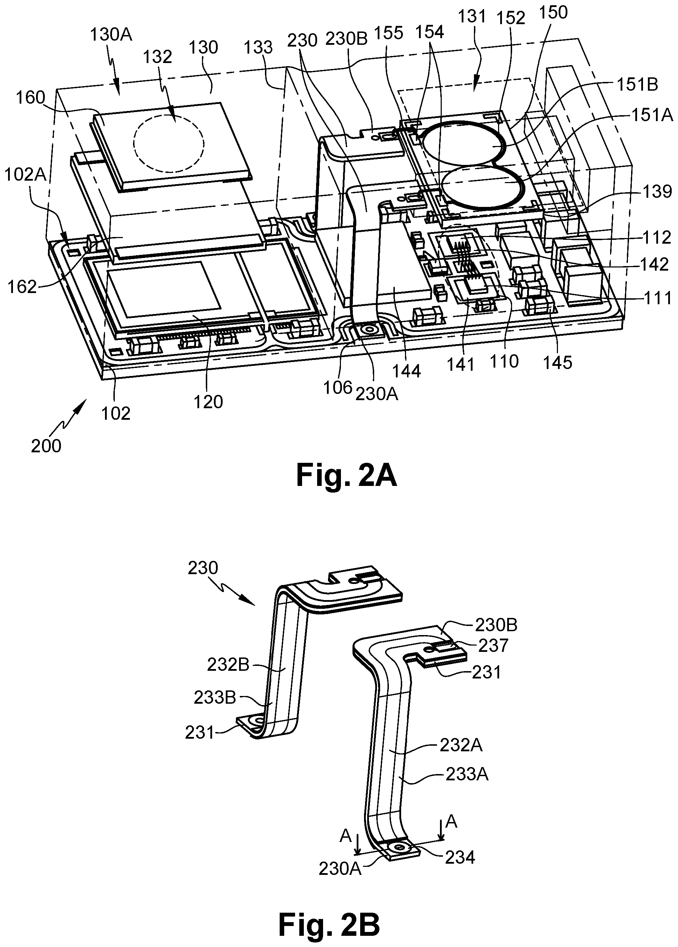

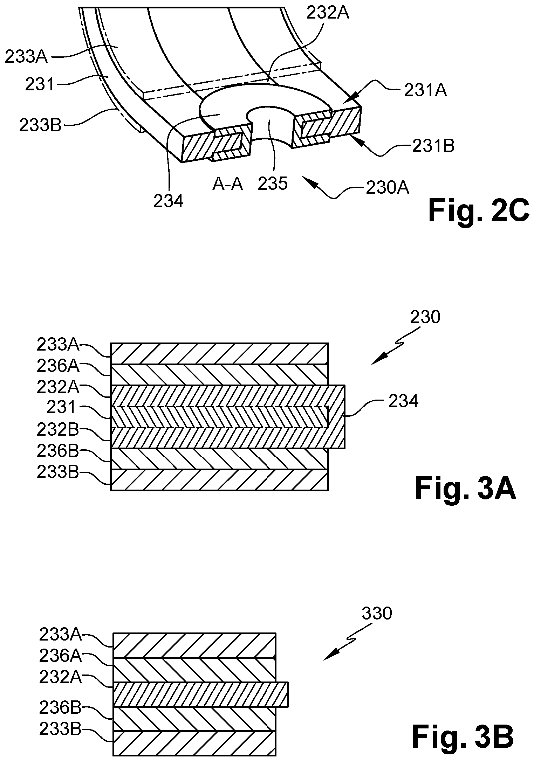

Figure 2A, Figure 2B and Figure 2C are 3-dimensional views of an optical sensor module 200 according to an embodiment. Figure 2B shows in more detail connecting flexes of the optical sensor module. Figure 2C corresponds to an AA cross-section view of one of the connecting flexes 230.

The optical sensor module 200 of Figures 2A, 2B and 2C mainly differs from the optical sensor module 100 of Figure 1 in that, instead of having conductive leads, for example lead frames, assembled to the module cap 130, the optical sensor module 200 comprises two connecting flexes 230 assembled to the module cap 130. The other elements of the optical sensor module 200 may be similar to those of the optical sensor module 100 of Figure 1: those elements have the same numeral references as in Figure 1 and are not described again.

Each connecting flex 230 comprises at least one metal layer covered by, or encapsulated in, at least one dielectric layer to electrically isolate the connecting flex from other conductive elements of the optical sensor module 200, except at parts of said connecting flex in which the at least one dielectric layer is opened, in order to access the at least one metal layer for an electrical connection. Therefore, at the opened parts, for example ends, of the connecting flex 230, the at least one metal layer is adapted to be electrically coupled to components of the optical sensor module 200.

In the example of figures 2B and 2C, each connecting flex 230 comprises two metal layers, a first metal layer 232A and a second metal layer 232B, electrically isolated from one another by a dielectric core 231.

For example, the first and second metal layers 232A, 232B are embedded in the dielectric core 231, the first metal layer 232A flush with a first face 231A of the dielectric core, and the second metal layer 232B flush with a second face 231B of the dielectric core.

For example, the first and second metal layers 232A, 232B have a width which is less than the width of the dielectric core 231, and are substantially centered with respect to the dielectric core, such that the first and second metal layers 232A, 232B do not reach the edges of the connecting flex 230. Therefore, the edges of the connecting flex 230 are electrically isolated.

For example, the first and second metal layers 232A, 232B form metal strips within the dielectric core 231.

Each connecting flex 230 further comprises two dielectric layers 233A, 233B: a first dielectric layer 233A covering the first metal layer 232A, and a second dielectric layer 233B covering the second metal layer 232B. The first dielectric layer covers the face of the first metal layer which is not isolated by the dielectric core, and similarly the second dielectric layer covers the face of the second metal layer which is not isolated by the dielectric core.

The first and second dielectric layers 233A, 233B may also at least partially cover the first and second faces of the dielectric core 231, as illustrated in Figures 2B and 2C in which the first and second metal layers 232A, 232B are embedded in the dielectric core 231 and have a width which is less than the width of the dielectric core 231.

The first and second metal layers 232A, 232B may be coupled to each other at a first end 230A of the connecting flex 230 by a metal part 234, for example a metal button having a hole 235, as illustrated in figures 2B and 2C. The metal part 234 is preferably not covered, or at least partially not covered, by the first and second dielectric layers 233A, 233B. The metal part 234 forms a conductive pad (second conductive pad) of the connecting flex 230.

The metal part 234, that is the second conductive pad, may be coupled to one of the first conductive pads 106 of the substrate 102 by a conductive adhesive, for example a conductive glue, or a conductive solder.

At a second end 230B of the connecting flex 230, the first dielectric layer 233A is opened in order to access the first metal layer 232A for an electrical connection, such that the first metal layer 232A can be connected to the conductive trace 152, for example through one of the third conductive pads 154. For example, the first metal layer 232A ends in a fourth conductive pad 237 which is coupled to the third conductive pad 154, for example though a conductive wire 155 formed by wire bonding. The conductive trace 152 corresponds to a component (first component) which is coupled to the substrate 102 through the connecting flex 230.

In a variant, each connecting flex 230 may be coupled to the conductive trace 152 of the glass 150 using a conductive adhesive, or a conductive solder.

The second dielectric layer 233B may also be opened in order to access the second metal layer 232B for an electrical connection. For example, the second metal layer 232B may also end in a conductive pad, or in the fourth conductive pad 237.

The dielectric material of the dielectric core and/or the dielectric layers is, for example, a polyimide. Advantages of polyimide are that it can be thermosetting as well as thermoplastic, and has a very high thermal stability, it also exhibits excellent dielectric properties and inherently low coefficient of thermal expansion. In addition, polyimide can endure high temperatures such as the ones encountered during a reflow, for example 500°C or more.

The metal of the metal layers and/or of the metal part of the connecting flex is, for example, copper.

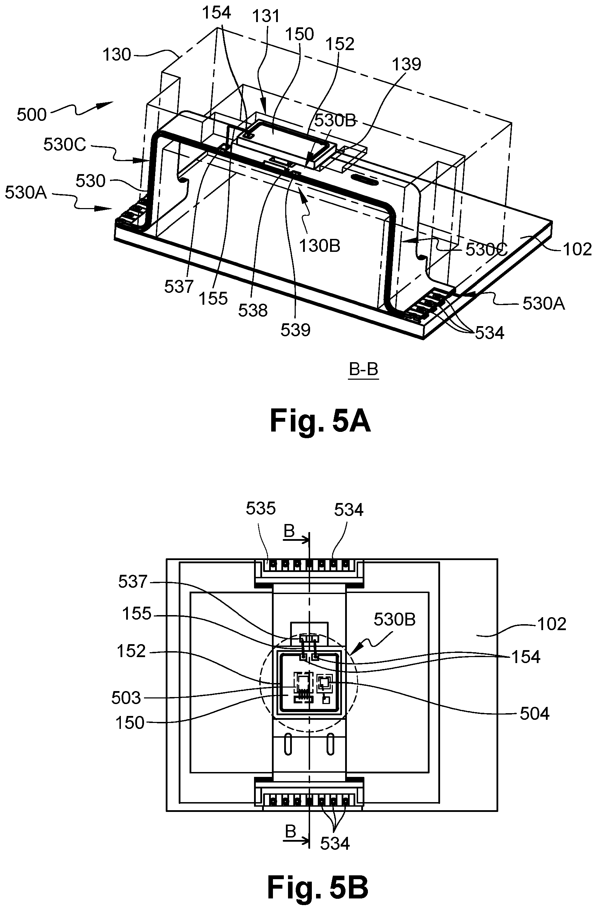

In a variant, the two metal layers 232A, 232B may not be coupled to one another. For example, one of the two metal layers may be coupled to ground, and the other of the two metal layers may be dedicated to the conduction of an electrical signal, as illustrated in the example of Figures 5A to 5D.

In another variant, the connecting flex may comprise only one metal layer, as illustrated in Figure 3B described hereafter.

In another variant, the connecting flex may comprise more than two metal layers, two adjacent metal layers being preferably isolated from each other by a dielectric material.

In a variant, instead of having two dielectric layers at each face of the connecting flex, the connecting flex may comprise a dielectric layer arranged to envelop, or encapsulate, the connecting flex.

The glass 150 may comprise, or consist in, a glass window, a lens or a plurality of lenses, and/or an optical filter.

Each connecting flex 230 may be overmolded in the module cap 130.

Similarly to the optical sensor module 100 of Figure 1, the module cap 130 of the optical sensor module 200 may be a plastic cap, and/or a molded cap formed of a molding material, such as a resin, a Liquid Crystal Polymer (LCP), a polyamide, Nylon, or another engineering plastic. The module cap 130 may be formed using an injection molding method. In a variant, the module cap 130 may be electrically conductive, for example a molded cap formed of a molding material, for example one of the above-cited molding materials, filled with electrically conductive particles dispersed therein. When the module cap is conductive, using a connecting flex is advantageous because the metal layer(s) of the connecting flex can be isolated from the conductive module cap by the dielectric layer(s) and/or dielectric core.

Examples of conductive module caps are described in more detail in the French patent application number 2311561, filed on October 25, 2023 in the name of STMICROELECTRONICS INTERNATIONAL N.V. (law firm reference being B22689), entitled "Optical sensor module", and in the European patent application claiming the priority of the French patent application number 2311561, which are hereby incorporated by reference to the maximum extent allowable by law.

The other features of the optical sensor module 200 of Figures 2A and 2B may be similar to that of the optical sensor module 100 of Figure 1.

In a variant, the optical sensor module may not comprise a conductive trace, but may comprise one or more other component(s) positioned on or under the glass and coupled to one or more connecting flex(es).

In a variant, the optical sensor module may not comprise a glass, but may comprise one or more components which are not positioned on or under a glass and are coupled to one or more connecting flex(es).

In a variant which may be combined with the precedent variants, one or more component (s) may be positioned on a connecting flex. An example is shown in Figures 5A to 5D described hereafter.

In Figures 2A and 2B, two connecting flexes have been represented. This is not limitative, and the optical sensor module may comprise one connecting flex. The optical sensor module may also comprise more than two connecting flexes.

Figure 3A is a schematic cross-section view of the connecting flex of Figures 2B and 2C. Figure 3A schematically illustrates the different layers of the connecting flex 230, as well as the metal button 234 which protrudes from the rest of the connecting flex. Figure 3A further illustrates a first adhesive layer 236A between the first metal layer 232A and the first dielectric layer 233A, and a second adhesive layer 236B between the second metal layer 232B and the second dielectric layer 233B.

The thickness of the layers may vary. Ranges of thicknesses are given in Table 1 below, as non-limiting ranges.

**[Table 1]**

| Layer | Ranges of thickness (µm) |
|---|---|
| 233A | [10-100] or [20-50] |
| 236A | [10-100] or [20-50] |
| 232A | [10-50] or [15-35] |
| 231 | [10-100] or [20-50] |
| 232B | [10-50] or [15-35] |
| 236B | [10-100] or [20-50] |
| 233B | [10-100] or [20-50] |

Figure 3B is a schematic cross-section view of a connecting flex 330 of an optical sensor module according to another embodiment. The connecting flex 330 differs from the connecting flex 230 of Figure 3A mainly in that it comprises only one metal layer 232A, and in that it does not comprise a dielectric core. The metal layer 232A protrudes from the rest of the connecting flex 330, for example to be electrically coupled to the substrate.

The thickness of the layers may vary. Ranges of thicknesses are given in Table 2 below, as non-limiting ranges.

**[Table 2]**

| Layer | Ranges of thickness (µm) |
|---|---|
| 233A | [10-100] or [20-50] |
| 236A | [10-100] or [20-50] |
| 232A | [10-50] or [15-35] |
| 236B | [10-100] or [20-50] |
| 233B | [10-100] or [20-50] |

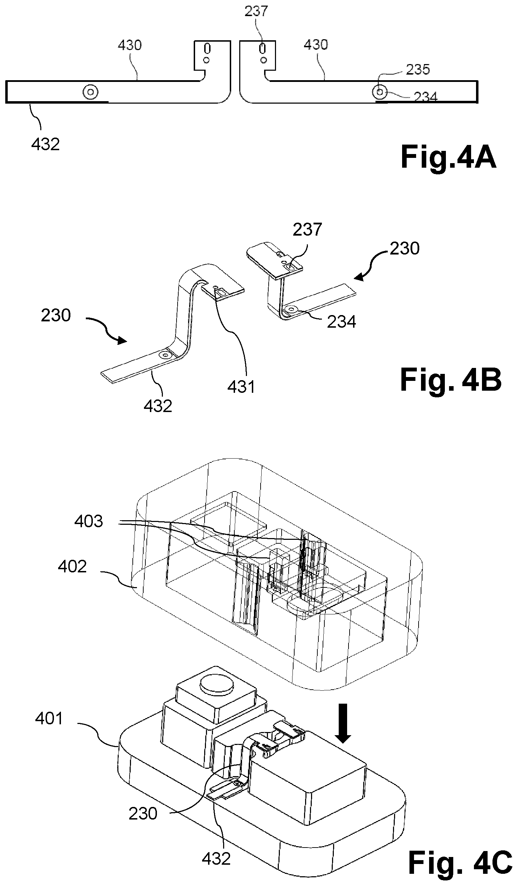

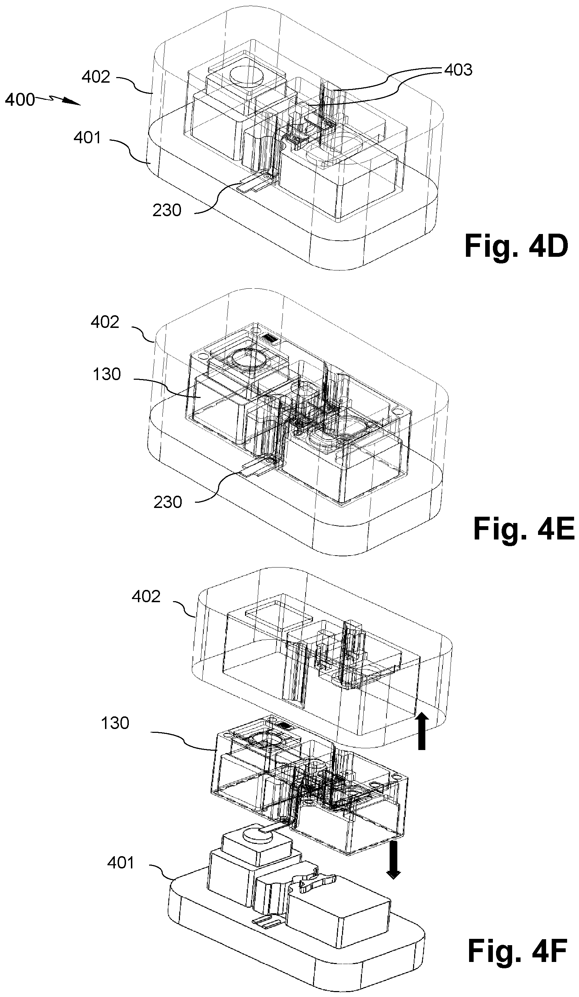

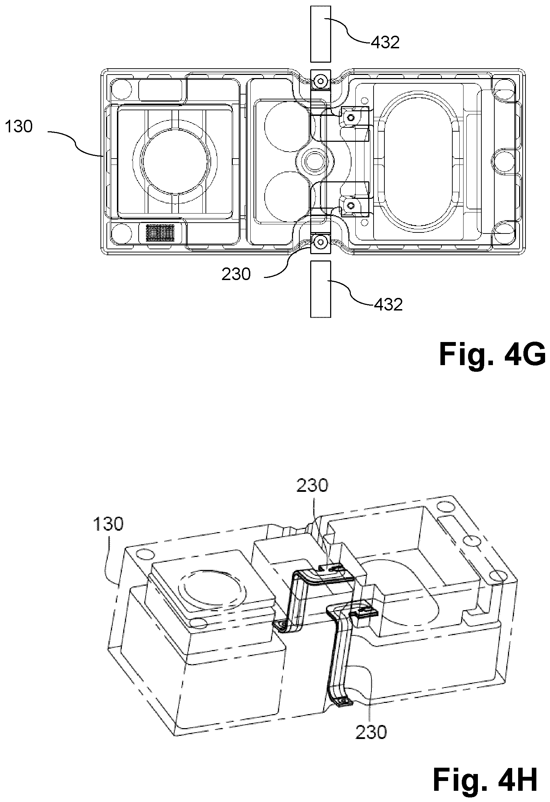

Figure 4A, Figure 4B, Figure 4C, Figure 4D, Figure 4E, Figure 4F, Figure 4G and Figure 4H are top and 3-dimensional views illustrating a method of assembling the connecting flex to the module cap in the optical sensor module of Figure 2A.

Figure 4A is a top view of a starting structure comprising 2D connecting flexes 430. In each 2D connecting flex, it can be seen the metal part 234, or second conductive pad, the hole 235 in the metal part 234, and the fourth conductive pad 237. In addition, each 2D connecting flex has tabs 432 extending the 2D connecting flex 430 beyond the metal part 234, in order to facilitate the assembling method, in particular to facilitate the holding of the connecting flex in the molding tool described hereafter.

Figure 4B is a 3-dimensional view of a structure obtained by bending the 2D connecting flexes 430 to a desired 3D shape, required for the subsequent molding, thus forming the connecting flexes 230.

Figure 4C is a 3-dimensional view of a structure obtained by placing the connecting flexes 230 into a mold core 401 of a molding tool 400 adapted to position these connecting flexes relative to the future module cap, and by approaching a mold cavity 402 of the molding tool 400. The mold cavity 402 includes holding inserts 403 which are adapted to hold the connecting flexes 230 in place during the subsequent molding.

Figure 4D is a 3-dimensional view of a structure obtained when the mold cavity 402 and the mold core 401 are closed, with the holding inserts 403 securing the connecting flexes 230 to their intended positions. The connecting flexes 230 are hold in place for the subsequent molding thanks to the holding inserts 403 which are introduced into holes 431 in the connecting flexes (shown in Figure 4B).

Figure 4E is a 3-dimensional view of a structure obtained after an injection molding step in which a molding material is injected into the mold cavity 402, forming the module cap 130 made of the molding material. After the injection molding step, the connecting flexes 230 are overmolded in the module cap.

Figure 4F is a 3-dimensional view of a structure obtained after the molding tool 400 is opened, that is, after the mold core 401 and the mold cavity 402 are moved away from one another. The module cap 130 is ejected from the molding tool 400 when this molding tool is opened.

Figure 4G is a top view of a structure obtained by cutting each connecting flex 230 in order to remove the tabs 432.

Figure 4H is a 3-dimensional view of the connecting flexes 230 assembled to, and overmolded into, the module cap 130.

Then, the module cap 130 assembled with the connecting flexes 230 may be assembled to the substrate.

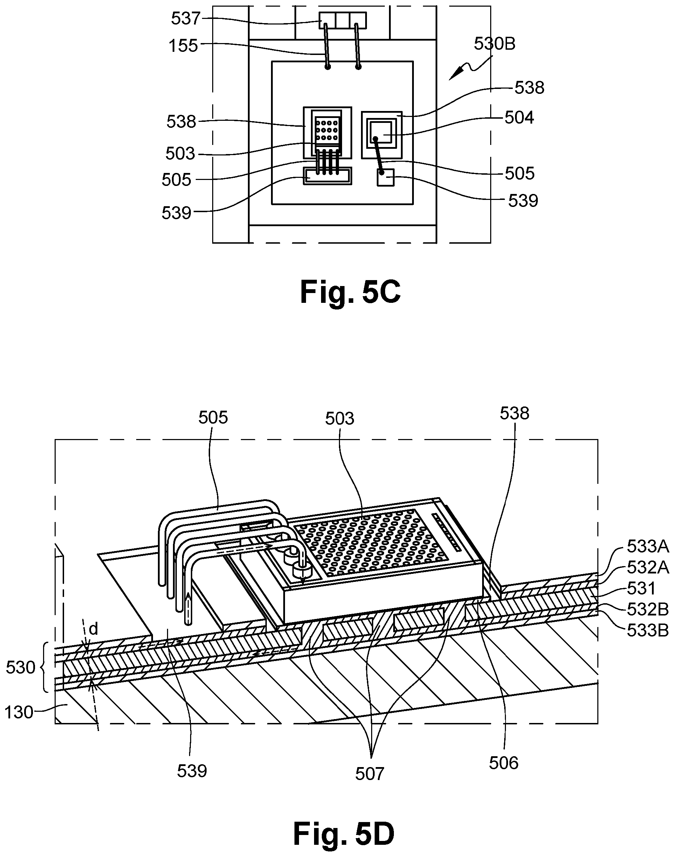

Figure 5A is a sectioned 3-dimensional view of an optical sensor module 500 according to another embodiment. Figure 5B is a top view of the optical sensor module 500 of figure 5A. Figure 5C is a top view illustrating a detail of the connecting flex 530 of the optical sensor module 500 of figures 5A and 5B. Figure 5D is a sectioned 3-dimensional view illustrating a detail of the connecting flex 530 of Figure 5C. Figure 5A represents only one half of the optical sensor module 500 cut in the BB direction shown in Figure 5B.

Similarly to the optical sensor module 200 of Figures 2A to 2C, the optical sensor module 500 of Figures 5A to 5D comprises a module cap 130 and a glass 150 sitting on a mounting 139 which is formed within a first opening 131 of the module cap 130. The glass 150 comprises a conductive trace 152 and third conductive pads 154 coupled to each end of the conductive trace.

The optical sensor module 500 of Figures 5A to 5D comprises one connecting flex 530.

The connecting flex 530 is adapted to receive one or several components 503, 504 (second component(s)) on itself, under the glass 150. The at least one second component may be a light source 503 such a VCSEL, and optionally a photodiode 504 which may be dedicated to monitor the light source 503. The at least one second component may be part of a light-emitting device. This is not limitative and other components may be positioned in recesses of the connecting flex. Figure 5D shows a detail of the light source 503, represented as a VCSEL, and of the connecting flex 530 on which the VCSEL 503 is mounted and to which the VCSEL 503 is coupled.

In the illustrated example, the connecting flex 530 includes recesses 538, adapted to receive the components 503, 504 under the glass 150.

The connecting flex 530 comprises a plurality of second conductive pads 534, which are adapted to be coupled to a plurality of the first conductive pads of the substrate 102 (not shown in Figures 5A to 5D).

The connecting flex 530 further comprises a plurality of fourth conductive pads 537 which are adapted to be coupled to the conductive trace 152 through the third conductive pads 154.

As illustrated in Figure 5D, the connecting flex 530 comprises a dielectric core 531, a first metal layer 532A on a first side of the dielectric core, a first dielectric layer 533A partially covering the first metal layer, a second metal layer 532B on a second side of the dielectric core, and a second dielectric layer 533B covering the second metal layer, similarly to the connecting flex of Figures 2C and 3A except that the first and second metal layers are not coupled to each other.

The recess 538 which receives the VCSEL 503 goes through the entire thickness of the first dielectric layer 533A and the first metal layer 532A up to the dielectric core 531.

The first metal layer 532A is dedicated to the conduction of electrical signals.

The first metal layer 532A terminates at each end 530A of the connecting flex 530 with the second conductive pads 534. For example, openings in the first and second dielectric layers 533A, 533B, the dielectric core 531 and the second metal layer 532B may allow coupling the first metal layer 532A to the first conductive pads of the substrate 102 through the second conductive pads 534.

The first and second dielectric layers 533A, 533B of the connecting flex 530 may comprise, for example may terminate with, a plurality of isolating elements 535 at each end 530A of the connecting flex 530, and each second conductive pad 534 may be interposed between a couple of isolating elements 535. The isolating elements may be finger shaped.

The fourth conductive pads 537 may correspond to openings in the first dielectric layer 533A to access the first metal layer 532A, in a top portion 530B of the connecting flex 530.

The first metal layer 532A may be split into a plurality of metal traces electrically isolated from each other by the dielectric material, and each metal trace may be coupled to a dedicated second conductive pad 534. Therefore, different electrical signals may be conducted by different metal traces and second conductive pads. For example, at least a first metal trace of the first metal layer 532A is dedicated to the conduction of electrical signals of the VCSEL 503.

The second metal layer 532B is adapted to be coupled to ground.

The connecting flex 530 further includes bond conductive pads 539 adapted to electrically couple the components 503, 504 to the connecting flex 530, for example through conductive wires 505 (wire bonding). Preferably, the bond conductive pads 539 are electrically in contact with, or terminate, the first metal layer 532A, for example through openings in the first dielectric layer 533A in the top portion 530B of the connecting flex 530, so that the components 503, 504 may be coupled to the first metal layer 532A, as illustrated in Figure 5D. For example, the VCSEL 503 is electrically coupled to the connecting flex 530, in particular to the first metal layer 532A, through one of the bond conductive pads 539 using some of the conductive wires 505.

The VCSEL 503 is positioned on a third metal layer 506 positioned in the recess 538. The third metal layer 506 is electrically isolated from the first metal layer 532A and is electrically coupled to the second metal layer 532B by at least one connecting via 507, for example a plurality of connecting vias, and therefore is adapted to be coupled to ground. The third metal layer 506 is preferably coplanar with the first metal layer 532A.

It should be contemplated that the recess 538 which receives the photodiode 504 may be similar to the recess 538 that receives the VCSEL 503, and that the connections of the photodiode 504 with the connecting flex 530 may also be similar to that of the VCSEL with the connecting flex.

The connecting flex 530 comprises:
- the two ends 530A (end portions) configured to be connected to the substrate 102, the second conductive pads 534 and the isolating elements 535 being defined in each of these end portions;
- the upper portion 530B, this upper portion being at least in part in contact with an internal surface 130B of the module cap 130, the recesses 538 being defined in this upper portion, as well as the fourth conductive pads 537 and the bond conductive pads 539; and
- two interconnecting portions 530C, each end portion 530A being connected to the upper portion 530B by means of one of the interconnecting portions 530C, each interconnecting portion being disposed substantially perpendicularly to the upper portion.

Therefore, the connecting flex 530 has a curved shape.

The connecting flex 530 allows having multiple second conductive pads 534 adjacent to each other, and isolated from each other by the isolating elements 535. Since metal traces in the connecting flex 530 are isolated from each other by the dielectric material, as well as the second conductive pads 534, therefore there is less short circuit risk even if the connecting flex is deformed during molding. The pitch between the second conductive pads 534 can be of a hundred micrometers.

Positioning components on the connecting flex allows the components to be closer to the glass compared to those mounted on the substrate. In an example, the glass 150 is a lens and the component 503 is a light source such as a VCSEL, and the light from the light source may be divergent, for example may have a conical shape. The more the distance between the light source and the lens, the more the lens size may be increased to cover the light cone, and inversely, the less the distance, the more the lens size may be decreased to cover the light cone. This also allows accurately position each component with respect to the glass. In the example in which the glass 150 is a lens and the component 503 is a light source such as a VCSEL, positioning the component on the connecting flex allows well aligning the lens in the three directions of the space relative to the VCSEL.

Figure 5D illustrates an advantage of the connecting flex. Indeed, it can be observed that the distance d between the signal layer (first metal layer) and the ground layer (second metal layer) can be substantially stable, which allows having a characteristic impedance, and a very good signal integrity. In addition, the signal layer can be very close to the ground layer and the current loop, illustrated by the dotted arrows, can be small, which may allow better electrical performance, for example better EMI performance.

The connecting flex according to the embodiments has other advantages such as:
- the possibility to have a high density of metal traces in the metal layer(s);
- the metal layer(s), and the metal traces, in the connecting flex may be insulated from the module cap, which is advantageous if the module cap is electrically conductive;
- the design of the connecting flex is flexible; parameters which can be adapted are for example: the number of metal layers, each comprising one or a plurality of metal traces; the dimensions, thicknesses and materials of the different layers; the shape of the dielectric layer(s); the use of a dielectric core or not; the dimensions and thickness of the connecting flex; the formation of a recess to receive a component or not ...

An application of the embodiments is for managing the above-mentioned electromagnetic interferences (EMI) through the first opening of the module cap, using a conductive trace in a glass in the first opening and/or covering the first opening, for example by providing EMI reflection in said first opening. In this application, one connecting flex may be enough, for example to couple the conductive trace to ground.

Another application of the embodiments is for managing the above-mentioned safety problem related to the light-emitting device, that is, to detect whether the glass is removed or otherwise becomes detached from the module cap, using a conductive trace in the glass. When the glass is in position, the connecting flexes, the conductive wires and the conductive trace form a conductive loop, for example through conductive paths in the substrate. If, however, the glass becomes detached, the circuit in the conductive loop may be opened, a detection circuit may detect the open circuit, and for example may deactivate the light-emitting device. In this application, it is generally necessary to have two connecting flexes to form a conductive loop.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

## Claims

1. An optical sensor module (200; 500) comprising:
- a substrate (102) comprising first conductive pads (106);
- a module cap (130) assembled on the substrate;
- a connecting flex (230; 330; 530) incorporated in the module cap, the connecting flex being adapted to electrically couple at least one of the first conductive pads (106) to at least one component (152; 503, 504) mounted on and/or inside the module cap;
the connecting flex (230; 330; 530) comprising at least one metal layer (232A, 232B; 532A, 532B) covered by, or encapsulated in, at least one dielectric layer (233A, 233B; 533A, 533B).

2. The optical sensor module (200; 500) according to claim 1, wherein:
- the connecting flex (230; 530) is overmolded in the module cap (130); and/or
- the module cap (130) is a conductive molded cap, for example formed of a molding material comprising electrically conductive particles dispersed therein.

3. The optical sensor module (500) according to claim 1 or 2, wherein:
- the at least one metal layer (532A, 532B) of the connecting flex (530) comprises, for example ends in, a plurality of second conductive pads (534) which are adapted to be coupled to a plurality of the first conductive pads (106) of the substrate (102); and
- the at least one dielectric layer (533A, 533B) of the connecting flex (530) comprises, for example ends in, a plurality of insulating elements (535), each second conductive pad (534) being interposed between two insulating elements (532).

4. The optical sensor module (200; 500) according to any of claims 1 to 3, further comprising a light-emitting device (110; 503, 504), the module cap (130) at least partially covering the light-emitting device and comprising a first opening (131) located over said light-emitting device, the light-emitting device being for example one of the at least one component.

5. The optical sensor module (200; 500) according to claim 4, further comprising a glass (150) positioned in the first opening or between the first opening and the light-emitting device, and/or covering the first opening, and adapted to transmit light signals emitted by the light-emitting device (110; 503), the glass including a conductive trace (152) which corresponds to a first component of the at least one component, the connecting flex (230; 530) being electrically coupled to the conductive trace, for example through a conductive wire (155) formed by wire bonding.

6. The optical sensor module (500) according to any of claims 1 to 5, wherein a second component (503, 504) of the at least one component is positioned on the connecting flex (530) .

7. The optical sensor module (500) according to claim 6, wherein the connecting flex (530) includes at least a recess (538) adapted to receive the second component (503, 504) .

8. The optical sensor module (500) according to claim 7 in combination with claim 3, wherein the connecting flex (530) comprises:
- at least one end portion (530A) configured to be connected to the substrate (102), the second conductive pads (534) and the insulating elements (535) being defined in said at least one end portion, and
- an upper portion (530B), said upper portion being at least in part in contact with an internal surface (130B) of the module cap (130), the recess (538) being defined in said upper portion.

9. The optical sensor module (500) according to claim 8, wherein the connecting flex (530) comprises two end portions (530A) and two interconnecting portions (530C), wherein each end portion is connected to the upper portion (530B) by means of one of the interconnecting portions, each interconnecting portion being disposed substantially perpendicularly to the upper portion.

10. The optical sensor module (500) according to claim 8 or 9, wherein the connecting flex (530) comprises:
- a first metal layer (532A) electrically coupled to the second component (503), for example by means of a conductive wire (505), the first metal layer being covered by a first dielectric layer (533A) of the at least one dielectric layer;
- a second metal layer (532B) configured to be connected to ground, the second metal layer being covered by a second dielectric layer (533B) of the at least one dielectric layer;
- a third metal layer (506) positioned in the recess (538) and electrically isolated from the first metal layer, the second component (503) being connected to said third metal layer, for example positioned on said third metal layer;
- a dielectric core (531) interposed between the first metal layer (532A) and the second metal layer (532B);
- at least one connecting via (507) defined in said dielectric core (531) and electrically coupling the third metal layer (506) to the second metal layer (532B).

11. The optical sensor module (500) according to claim 10, wherein the recess (538) goes through the entire thickness of the first dielectric layer (533A) and the first metal layer (532A) up to the dielectric core (531).

12. The optical sensor module according to any of claims 8 to 11, wherein the connecting flex (530) comprises a plurality of bond pads (539), said bond pads being defined on the upper portion (530B) of the connecting flex, each bond pad (539) being configured to be electrically coupled to the second component (503, 504), for example by means of a conductive wire (505).

13. The optical sensor module according to claim 12 in combination with claim 10 or 11, wherein the bond pads (539) go through the entire thickness of the first dielectric layer (533A) up to the first metal layer (532A).
